# EUROPEAN PATENT SPECIFICATION

(11) **EP 2 440 684 B1**
(45) Date of publication and mention of the grant of the patent: **31.10.2018**
(21) Application number: 10724759.5
(22) Date of filing: 03.06.2010
(51) Int. Cl.: C23C 16/27, C23C 16/26, G04D 3/00, B81B 3/00, C23C 16/56

(54) **METHOD FOR COATING MICROMECHANICAL COMPONENTS OF A MICROMECHANICAL SYSTEM, IN PARTICULAR A WATCH AND RELATED MICROMECHANICAL COATED COMPONENT**
VERFAHREN ZUM BESCHICHTEN VON MIKROMECHANISCHEN BAUTEILEN EINES MIKROMECHANISCHEN SYSTEMS, INSBESONDERE EINER UHR, UND ZUGEHÖRIGES MIRKOMECHANISCHES BESCHICHTETES BAUTEIL
PROCÉDÉ POUR LE REVÊTEMENT DE COMPOSANTS MICROMÉCANIQUES D'UN SYSTÈME MICROMÉCANIQUE, EN PARTICULIER D'UNE MONTRE, ET COMPOSANT MICROMÉCANIQUE REVÊTU CORRESPONDANT

(30) Priority: 09.06.2009 EP 09162327
(43) Date of publication of application: 18.04.2012
(73) Proprietor: The Swatch Group Research and Development Ltd., 2074 Marin (CH)
(72) Inventor: STEINMÜLLER, Detlef, 6074 Aldrans (AT); STEINMÜLLER, Doris, 6074 Aldrans (AT); DREXEL, Herwig, 6080 Igls (AT); GHODBANE, Slimane, 6074 Aldrans (AT); RICHARD, David, 1400 Yverdon-les-Bains (CH); CUSIN, Pierre, 1423 Villars-Burquin (CH)
(74) Representative: Ravenel, Thierry Gérard Louis
(86) International application number: PCT/EP2010/057802
(87) International publication number: WO 2010/142602

(56) References cited:
- EP-A1- 0 732 635
- DIPALO M ET AL: "N-type doped nano-diamond in a first MEMS application", PHYSICA STATUS SOLIDI A WILEY-VCH GERMANY, vol. 203, no. 12, September 2006 (2006-09) , pages 3036-3041, XP002609909, ISSN: 0031-8965
- SHIBATA T ET AL: "Micromachining of diamond film for MEMS applications", JOURNAL OF MICROELECTROMECHANICAL SYSTEMS IEEE USA, vol. 9, no. 1, March 2000 (2000-03), pages 47-51, XP002610208, ISSN: 1057-7157

## Description

### FIELD OF THE INVENTION

This invention relates to micromechanical parts with high tribological performances (low friction and wear) for application in mechanical systems and namely a method for coating micromechanical components of a micromechanical system, in particular a watch, for preventing the agglomeration of particles (debris and/or dust) on the functional areas of micromechanical components. The invention also relates to a micromechanical component for a micromechanical system, in particular a watch movement coated with said method. The invention can be used in micromechanical watch movements, in particular for the realisation of escapement wheels and pallets and other friction-relevant components.

### BACKGROUND TO THE INVENTION

The technical demands relating to micromechanical components are growing: beside highest precision, the components need to provide highest energy efficiency in the mechanical system, long lifetime and complete abdication of lubricants insofar as possible.

Many documents related to such characteristics have been published. The approaches presented generally fulfil some of the tasks without being able to deliver a complete solution mainly due to the restrictions on the materials used.

Micromechanical components produced by mechanical machining (die cutting or shape cutting) exhibit two major disadvantages: firstly, they are either high priced or economically profitable only in mass production because investments are required for expensive production tools. Secondly, these processes did reach their technical limits with the accuracy lying by +/- 5 micrometers.

Several alternative approaches have been discussed in literature; the most promising idea being the etching of micromechanical parts from silicon wafers achieving highest precision exceeding the results of the machining techniques by far. In practical results, it was shown that the required mechanical strength as well as coefficient of friction of some micromechanical components very often exceed the known components characteristics. For instance, in the watch industry, this causes problems in the handling of the parts and in the regularity of the performance and reliability of watches on short and long terms.

A solution to the problem has been demonstrated in EP 1 904 901 in which it is disclosed that by treating the surface of the micromechanical parts with oxygen the strength and the lifetime could be extended.

The energy efficiency could be enhanced by using special oils in mechanical systems, however at the expense of the demand for a dry running system.

Classical machined parts made of steel achieve the longest lifetime, but these systems have to be lubricated to perform their function.

A further problem of the lubricated systems is the necessity for frequent service intervals, where the movements have to be cleaned and re-lubricated. Numerous approaches to fulfil all these requirements with one system have been undertaken:
EP0732635B1 describes an approach where the micromechanical parts are etched from a silicon wafer and then coated with diamond films. The diamond films obtained via this method have a surface roughness higher than 400nm. These films require a subsequent polishing if the diamond-coated parts are used in sliding contact applications.

EP1233314 discloses a mechanical clockwork assembly for watches having a mechanical escapement with an escapement wheel and an anchor wherein the functional elements of the escapement wheel are at least partially coated on their operating surfaces with a DLC (diamond like carbon) coating. DLC has a high sp² content (ranging from 30 to 80%) and is amorphous carbon which hardness could not be sufficient for effective wear protection applications.

EP1622826 discloses a micromechanical component comprising a first surface and a second surface, which are substantially perpendicular to each other wherein the first and/or the second surface consist at least partially of diamond.

US 5308661 discloses a process for the pre-treatment of a carbon-coated substrate to provide a uniform high density of nucleation sites thereon for the subsequent deposition of a continuous diamond film without the application of a bias voltage to the substrate.

EP1182274A1 discloses a method for the post-treatment of diamond coatings where a coarse grained (micrometer regime) diamond coating is deposited on machining tools and subsequently treated by means of plasma processes. The aim of this post-treatment is the degradation of the top layers of the sp³-hybridised diamond coating into sp²-hybridised carbon species. The expected effect is a filling of the "surface valleys" between the coarse grains protruding from the surface to achieve a more flat surface. The result of such method is a film having a coarse grain sp³ diamond on top of which is a top layer of several hundred nanometres of sp² hybridised amorphous carbon. The top layer is relatively soft and wears off quickly in applications involving high friction forces.

US 2 996 763 discloses a radioactive diamond material, i.e. diamond material containing a surface coating of a radioactive metal to avoid the diamond material retaining a charge of static electricity. This document mentions the problem of dust attraction and agglomeration on the diamond surface, when diamond is used as bearing material in timepieces. This solution may prove efficient. However, nowadays the use of a radioactive element in a timepiece could be not be envisaged.

US 2008/0145675 discloses an anti-static surface treatment for a plastic film or similar material, where an additive that produces the anti-static properties is included in the surface. This document discloses additives in the form of siliconised top layer. This type of top layer does not resist to wear. Alternatively the additive can be graphite incorporated in the surface layer. However, this anti-static surface cannot be used in mechanical systems because the siliconised surface does not exhibit the necessary mechanical properties. Covering the diamond layer with such a siliconised layer could bury the diamond excellent mechanical properties.

US6080445 discloses a method for forming films over an insulating material wherein an underlayer film having electrical conductivity is formed on the surface of the insulating material constituting a substrate, and a hard carbon film is formed over the underlayer film so that the surface electrical resistance value of the hard carbon film can be controlled so as not to cause the surface thereof to be charged with static electricity by varying an electrical resistance value of the underlayer film. In such a method, the charges once evacuated through the thin conductive layer can not go elsewhere and accumulate in the conductive layer.

The above-described solutions can only partially solve the problem of preventing the retention of charges of static electricity satisfactorily. In particular, several deficiencies restrain the use in large-scale production, which is demanded in the watch industry for instance.

Indeed, the use of diamond-coated silicon micromechanical parts raises two major problems. First, as the diamond coatings are originally electrically insulating, electrostatic charges quickly build up upon use, due to friction and contact between the micromechanical parts. This charging effect leads to attraction of particles, which have a strong effect especially in unlubricated contacts. Moreover, fabrication of micromechanical parts for the watch industry can not practically be achieved in clean rooms or at least not be cost effective namely this means that the after sale service of watches equipped with such parts would also have to be carried out in clean room conditions which is unrealistic. Preventing any penetration of small particles of the environment (dust, skin-scurf, clothes, etc.) is therefore from a practical point of view not conceivable.

Another problem in micromechanical parts is based on the formation of a water thin film on their surface under ambient conditions. In particular, this has been described for CVD-diamond films in the following documents: Petrini, D. and Larsson, K., J. Phys. Chem. C 111 (2007) 795- "A theoretical approach to the energetic stability and geometry of hydrogen and oxygen terminated diamond (100) surfaces", Larsson K. New Diamond Front Carbon Technol 2005;15:229e45 "Surface properties of diamond under atmospheric conditions: a quantum mechanical approach". The above publications are incorporated herein by reference. Such water film fosters the collection of dust particles on the surfaces leading to the generation of dust aggregates, which may cause the failure of the watch (blocking of the watch movement) when these diamond-coated silicon micromechanical parts are used in a watch movement.

### SUMMARY OF THE INVENTION

A general aim of the invention is therefore to provide a method and a device enabling elimination or reduction of particle (debris/dust) attraction in a micromechanical system.

A further aim of the invention is to provide a process allowing providing micromechanical components for a micromechanical system, in particular a watch movement, avoiding particle (dust/debris) attraction and accumulation.

A further aim of the invention is to provide a process allowing providing micromechanical components for a micromechanical system, in particular a watch movement, avoiding the formation of a water film on the surface of the components.

Still another aim of the invention is to provide micromechanical components for a micromechanical system, in particular a watch movement, avoiding particle (dust/debris) attraction and accumulation.

Yet another aim of the invention is to provide micromechanical components for a micromechanical system, in particular a watch movement, avoiding the formation of a water film on the surface of the components.

These aims are achieved thanks to a process for coating micromechanical components of a micromechanical system, in particular a watch movement, and a micromechanical component for a micromechanical system, as defined in the claims.

There is accordingly provided a method for coating micromechanical components of a micromechanical system, in particular a watch movement, comprising:
- providing a substrate component to be coated;
- providing said component with a diamond coating;
wherein said diamond coating conductivity is increased in order to reduce particle (dust/debris) attraction by the coated component when used in said micromechanical system.

Such a process enables increasing the electrical conductivity of the diamond films thereby decreasing the resulting resistivity of the nanocrystalline diamond film down to a few Ohm.cm, but preferentially down to 10⁻² Ohm.cm. Electrostatic charging effect is reduced or eliminated and particle (dust/debris) attraction is preferably totally eliminated.

The component having a diamond coating, advantageously produced by a CVD process may have a thickness between a few nanometres and several micrometer (preferably 3 or more nanometres, and most preferably around 10 nanometres).

The diamond layer is formed of diamond grains having a size less than 30 nm.

The diamond coating is preferably provided to have the following properties:
- diamond grain size below 10nm;
- a surface roughness below 30nm, preferably below 10nm;
- a coefficient of friction below 0.1, preferably below 0.05 and most preferably below 0.03;
- electrical resistivity of at most few OHM.cm, preferably 10⁻² OHM.cm or below;
- a hydrophobic or lipophobic or ultraphobic surface termination.

In a preferred embodiment, the diamond coating conductivity is increased in order to change the coating polarity from hydrophilic to hydrophobic, thus avoiding water film accumulation on the components.

Diamond coating is advantageously provided by CVD and during CVD deposition, electronic conductivity of said coating is increased by doping the diamond film. Such process is reliable, allowing the production at a reasonable cost of a large number of components if required.

Several variants are possible for doping the diamond film, such as adding a dopant in gaseous, liquid, solid and/or vapour form during the deposition process. In such a case, the dopant is one material or a combination of the materials selected from the group consisting of boron, phosphorus, nitrogen, sulphur, arsenic, and aluminium. In other variants, doping is achieved by means of ion implantation, ion bombardment or sputtering technique. Doping may also be achieved by depositing adsorbates. In further variants, doping is achieved by deuteration and post-hydrogenation, by lattice distortion. (e.g. via radiation), by terminating the nanocrystalline diamond surface with an element or material rendering the surface hydrophobic. In the latter variant, a preferred example of used element is fluorine, without being restricted to this element. Other atoms and molecules adsorbed/attached/bound to diamond surface can induce the same effect, resulting again in strong hydrophobicity (surface unfavourable for water adhesion) or lipophobicity (surface unfavourable for oil adhesion). Preferred examples are: wax, oils, without being restricted to them. In still a further variant, termination is advantageous provided using an element selected from the list consisting of hydrogen, halogens, metals, electrical conductive minerals/organic molecules or proteins.

The invention also provides a micromechanical component for a micromechanical system, in particular a watch movement, wherein said component is obtained with a method as previously described.

Such component can be used to eliminate the particle (debris/dust) attraction in any other macroscopic or microscopic mechanisms where at least one component can be coated with conductive diamond to prevent dust attraction.

Such mechanical components, produced for micromechanical systems are long-time stable, allow high energy efficiency, prevent the collection of dust or other impurities at local areas on movements or micromechanical parts, allow the running of the mechanical system under dry (unlubricated) conditions, thus eliminating the need of regular maintenance.

The bearings of the micromechanical system are advantageously coated with such electrically conductive nanocrystalline diamond coating. Variants in which the bearings of the micromechanical system and the glues used are electrically conductive to allow electrical charges to be evacuated are also provided.

The invention further provides a micromechanical system; in particular a watch movement, comprising a component obtained with a method as previously described, and further comprising at least one silicon base component, wherein said silicon base material is electrically conductive.

In other variants, the micromechanical system may comprise other components made of a base material selected from the following list comprising silicon, silicon-oxide, silicon carbide, silicon-nitride, ceramics, nitrides, metals, cemented carbide, graphite, carbon-based materials, composites, glass or combinations thereof without being restricted to these materials.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings, in which:
- Figure 1 is a diagram showing the average coefficient of friction of a nanocrystalline diamond film sliding on a nanocrystalline diamond film without lubrication as a function of the diamond grain size;
- Figures 2a and 2b are schematic representations of the surface structure of a diamond film deposited according to the method of the invention for different grain sizes, resulting in a low roughness, and therefore a low coefficient of friction, when the grain size is the smallest; and
- Figures 3a and 3b illustrates how the hydrophobic diamond surface obtained after fluorination prevents the accumulation of dust on the whole surface.

### DETAILED DESCRIPTION OF THE INVENTION

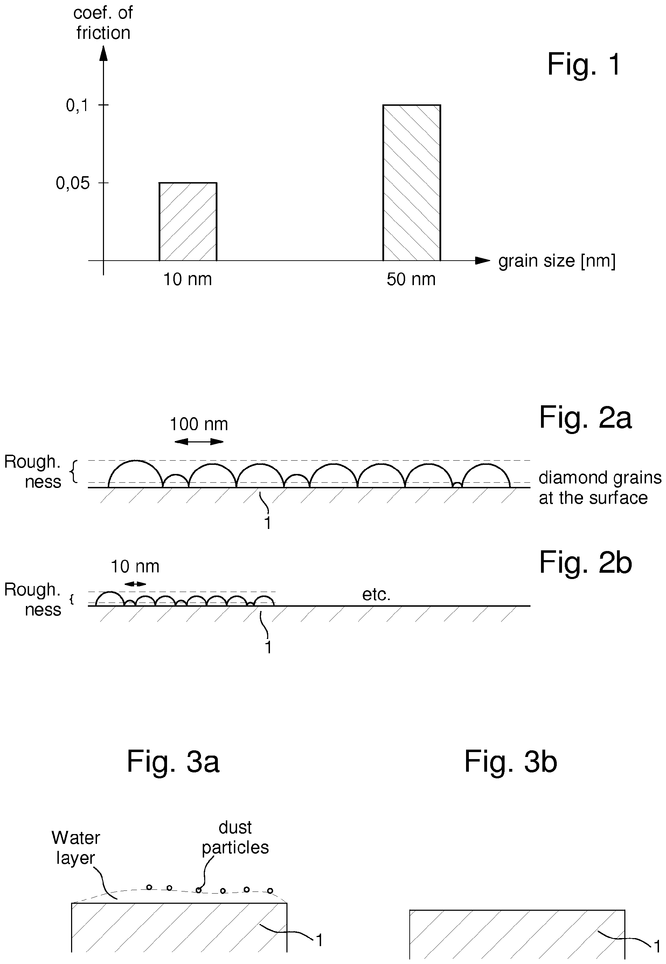

The invention presented is based on micromechanical components coated with NCD (nanocrystalline diamond) films of thicknesses between tens of nanometers and several micrometers. The crystals or grains have a size of a few nanometers, preferably less than 10 nanometers, as shown in Figure 1. These diamond films comprise a coefficient of friction of less than 0.1, preferably less than 0.05, in special cases 0.03 or less. Such nanocrystalline diamond films are produced by a CVD (chemical vapour deposition) process. In an advantageous CVD process (discloses in AT399726B incorporated herein by reference) a carbon containing gas species (for example methane) is thermally activated and is deposited on a substrate as diamond (sp³-hybridised carbon), as graphite (sp²-hybridised carbon) as well as carbon hydrates or other carbon species (mixtures of sp²- and sp³-hybridised carbon). To obtain a pure diamond layer it is necessary to use a second gas: for instance hydrogen. The hydrogen gas (H₂) is also thermally activated resulting in mono-atomic hydrogen, where, as an important process step, the efficiency of the activation process is extremely high (more than 50%), preferably more than 75% and achieving in special cases 90% or more. Such a method is described in AT399726B.

With this process, the nanocrystalline diamond coatings 1 (Figure 2) can be deposited on silicon, with diamond crystal sizes of less than 8 nanometers having a surface roughness of less than 10 nanometers for instance as shown in Figure 2b.

The solution of the described dust-problem due to electrostatic charging effect can be achieved by increasing the electrical conductivity of the diamond films thereby decreasing the resulting resistivity of the nanocrystalline diamond film down to a few Ohm.cm, but preferentially down to 10⁻² Ohm.cm.

A sufficient conductivity of the diamond layer and the change of its polarity (hydrophilic/hydrophobic) can be achieved using the following methods or processes:
- Doping of NCD films by incorporation of atoms or molecules: during the diamond growth a dopant in gaseous, liquid, solid and/or vapour form is added. For instance, boron-doped diamond films (p-type) or phosphorous-doped diamond films (n-type) are used to increase electrical conductivity. Further noted dopants are: nitrogen, sulphur, silicon, arsenic etc. without being limited to these elements.
- Boron doping (p-type): This process is achieved during the growth of diamond using a solid, liquid or gaseous source of boron. The substitution of a part (up to 0,1 %) of the carbon atoms from diamond by boron atoms leads to the generation of holes (lack of electrons). The ionisation energy of boron is 0,37 eV and thus very low. This allows the generation of a sufficient quantity of the free charge carriers. The availability of free charge carriers (in this case holes) increases the electrical conductivity of the diamond film. The electrostatic charges are thus evacuated to the bulk of the diamond film. The attraction of particle (debris/dust) is therefore considerably reduced or totally eliminated. The higher the boron concentration in diamond, the higher is the diamond conductivity, in the range of 10¹⁶ - 10²¹ cm⁻³. The resistivity can decrease down to 10⁻² Ohm.cm.
- Phosphorus doping (n-type): The phosphorus incorporation is achieved during the growth of diamond from a solid, liquid or gaseous source of phosphorus or phosphorus compounds such as TBP (tertiarybutylphosphine) and TMP (trimethylphosphate). The substitution of a part of carbon atoms from diamond by phosphorus atoms leads to an excess of electrons. The ionisation energy of phosphorus is 0,6 eV and thus relatively low, and frees a certain part of the provided electrons. The availability of free charges carriers (electrons in this case) increases the electrical conductivity of the diamond film. The electrostatic charges are evacuated to the bulk of the diamond film. The attraction of particle (debris/dust) is thus considerably reduced or totally eliminated. The higher the phosphorus concentration (in the range of 10¹⁶⁻ 10²¹ cm⁻³) in diamond, the higher is the diamond conductivity.
- Doping by other elements: a doping process can also be achieved by incorporating into diamond other elements such as sulphur, aluminium, nitrogen, and other elements or a combination of several elements.

In a first variant, doping is performed by means of ion implantation, ion bombardment or sputtering techniques: an ion beam is focused on a diamond film so that the ions are incorporated inside the diamond lattice (penetration depth depending on the dosage/energy of the ion beam). Some carbon atoms are replaced by the incorporated ions via bombardment (boron atoms for instance). The doping process and the behaviour of the conductivity are similar to the mechanism described above in connection with the doping of the diamond during growth. Other elements (phosphorus, sulphur, nitrogen, metals, etc) can also be implanted in diamond giving rise to an increase of its conductivity. Ion bombardment or sputtering of metals will destroy the near-surface lattice leading thus to increasing the diamond conductivity.

In a second variant, doping is performed by depositing adsorbates: depositing or adsorbing of a metal (silver, copper, gold, etc) or any other element/molecule on a part or the entire diamond surface might change the diamond band structure at the interface, thus increasing the conductivity for example as disclosed in Ref. Doping semiconductor nanocrystals, Steven C. Erwin et al. Nature 436, 91-94 (7 July 2005).

In a third variant, doping is performed by Deuteration and post-hydrogenation: after the growth of a boron-doped diamond, it is exposed to deuterium plasma and/or hydrogen plasma at a temperature lower than 500°C. This leads to the formation of Boron-2deuterium (BD₂) or Boron-2hydrogen (BH₂) complexes. The diamond film treated in this way exhibits n-type conductivity (generation of free electrons). For example as disclosed in "Shallow donors with high n-type electrical conductivity in homoepitaxial deuterated boron-doped diamond layers", Zéphirin Teukam et al. Nature Materials 2, 482 - 486 (2003).

In a fourth variant, doping is performed by post-treatment: including a plasma or laser treatment, also using gases changing the surface of diamond and/or being incorporated into its structure.

In a fifth variant, doping is performed by Lattice distortion (annealing in air or under controlled atmosphere, UV illumination, x-rays, ion implantation, etc.) to increase the diamond conductivity.

Surface conductivity may also be increased by termination, i.e. saturation of the dangling bonds (ligants) of the surface atoms of the diamond lattice. For example, hydrogen-termination of the diamond surface generates a surface conductivity, as described in "F. Maier, M. Riedel, B. Mantel, J. Ristein, and L. Ley, Phys. Rev. Lett. 85, 3472 2000". Additional alternatives of possible terminations are: halogens, metals, electrically conductive mineral/organic molecules and proteins.

In an advantageous configuration, the generation of the above mentioned problematic water film on the diamond surface can be prevented by terminating the nanocrystalline diamond surface with an element or material rendering the surface hydrophobic. The main example of such an element is fluorine, without being restricted to this element. Example of fluorination treatment is shown in Figures 3a and 3b illustrating H-terminated, with an average angle of 70° (Figure 3a) and F-terminated, with an average angle of 105° (Figure 3b) hydrophobic diamond surfaces 1. The F-terminated surface provides a substantially long-time stable solution. Other atoms and molecules either adsorbed or attached or bound to diamond surface can induce the same effect, resulting again in strong hydrophobicity (surface unfavourable for water adhesion) or lipophobicity (surface unfavourable for oil adhesion). Examples are: wax, oils, without being restricted to them. According to the invention, the termination can be achieved by covalently bonded adsorbates or by binding via H-bonds or Van-der-Waals forces without being restricted to them.

Examples of methods to terminate nanocrystalline diamond films are: wet chemical treatment, plasma processes, thermal processes, electrochemical processes (reduction, oxidation, electrolysis, etc), illumination in special atmospheres (UV, IR, etc.), spin-coating of adsorbates, sputtering of adsorbates, dip-coating of adsorbates, ink-jet with adsorbates, electro-spraying of adsorbates. Other techniques and processes may also be used.

By means of well-defined nano-structuring processes (lithography, etching of the NCD-surface), a so-called lotus-effect defined hereinafter can be obtained and thus the attachment of dust and the water film at the surface is prevented. Such nano-structures can be previously processed in the substrate itself (e.g. silicon). The nanometric scale of the diamond crystals and the low film thickness would be sufficient to maintain the geometry of the nanostructures and therefore maintain the lotus effect. The lotus effect refers to the very high water repellency (superhydrophobicity) exhibited by the leaves of the lotus flower, as described in Lafuma, A.; Quere, D. (2003). "Superhydrophobic states". Nature Materials 2: 457-460. Dirt particles are swept away by water droplets due to complex nanoscopic architecture of the surface which enables minimization of adhesion. This publication is incorporated herein by reference.

Combination of the methods described above: it is advantageous to use electrical conductive silicon as a substrate for all parts according to this invention in order to achieve the transport of electrical charges/current from the working surfaces. According to the invention, the conductive nanocrystalline diamond films are also be deposited on the bearing surfaces. Preferable substrates are silicon, silicon-carbide or silicon-nitride as bearing material without being restricted to these materials. Further substrate materials for bearings coated according to this invention are e.g.: ruby, tungsten carbide, ceramics, glass, etc.

When the parts are not fabricated from one silicon piece but glued together from different parts, conductive glues are preferably used.

The above detailed description with reference to the drawings illustrates rather than limit the invention. There are numerous alternatives, which fall within the scope of the appended claims. For instance, the invention can also be used to eliminate dust attraction in others macroscopic or microscopic mechanisms where at least one part/piece can be coated with conductive diamond to prevent dust attraction. Application examples are Micro-Electro-Mechanical Systems (MEMS), Nano-Electro-Mechanical Systems (NEMS), Electrical motors, in particular micro-motors, pumps, in particular micro-pumps, vacuum systems, static and/or kinetic systems such as engines, etc., without departing from the invention.

The word "comprising" does not exclude the presence of other elements or steps than those listed in a claim. The word "a" or "an" preceding an element or step does not exclude the presence of a plurality of such elements or steps. The mere fact that respective dependent claims define respective additional features, does not exclude a combination of additional features, which corresponds to a combination of dependent claims.

## Claims

1. Method for coating micromechanical components of a micromechanical system, in particular a watch movement, comprising:
- providing a substrate component to be coated;
- providing said component with a diamond coating;
- wherein said diamond coating conductivity is increased in order to reduce particle (debris/dust) attraction by the coated component when used in said micromechanical system, and wherein the diamond coating surface is further doped with an element or material rendering the surface hydrophobic said element or material being selected from the list including fluorine, wax, oils and wherein the diamond coating is deposited so as to be H-terminated or F-terminated
- , and wherein said diamond layer is formed of diamond grains having a size less than 30 nanometers and preferably less than 10 nanometers and most preferably less than 8 nanometers;.

2. Method for coating micromechanical components of a micromechanical system according to claim 1, wherein:
- diamond coating is provide by CVD;
- during CVD deposition, electronic conductivity of said coating is increased by doping the diamond film.

3. Method for coating micromechanical components of a micromechanical system according to claim 2, wherein said doping is achieved by adding a dopant in gaseous, liquid, solid and/or vapour form during the deposition process.

4. Method for coating micromechanical components of a micromechanical system according to claim 3, wherein the dopant is one material or a combination of the materials selected from the group consisting of boron, phosphorus, nitrogen, sulphur, arsenic, aluminium.

5. Method for coating micromechanical components of a micromechanical system according to claim 1, wherein electronic conductivity of said coating is increased by doping the diamond film, said doping being achieved by means of ion implantation, ion bombardment or sputtering technique.

6. Method for coating micromechanical components of a micromechanical system according to claim 1, wherein electronic conductivity of said coating is increased by doping the diamond film, said doping being achieved by depositing adsorbates.

7. Method for coating micromechanical components of a micromechanical system according to claim 1, wherein electronic conductivity of said coating is increased by doping the diamond film, said doping being achieved by deuteration and post-hydrogenation.

8. Method for coating micromechanical components of a micromechanical system according to claim 1, wherein electronic conductivity of said coating is increased by doping the diamond film, said doping being achieved by lattice distortion.

9. Method for coating micromechanical components of a micromechanical system according to claim 1, wherein electronic conductivity of said coating is increased by doping the diamond film, said doping being achieved by terminating the nanocrystalline diamond surface with an element or material rendering the surface hydrophobic.

10. Method for coating micromechanical components of a micromechanical system according to claim 9, wherein said termination is provided using an element selected from the list consisting of hydrogen, halogens, metals, electrical conductive minerals/organic molecules or proteins.

11. Micromechanical component for a micromechanical system, in particular a watch movement, wherein said component is obtained with a method according to anyone of claims 1 to 10.

12. Micromechanical component comprising a bearings according to claim 11, wherein the bearings are coated with electrically conductive nanocrystalline diamond according any one of claims 1 to 10.

13. Micromechanical component comprising bearings according to claim 11 or 12, wherein the bearings of the micromechanical system and the glues used are electrically conductive to allow electrical charges to be evacuated.

14. Micromechanical system, in particular a watch movement, comprising a component obtained with a method according to any one of claims 1 to 10, and further comprising at least one silicon base component, wherein silicon base material is electrically conductive.

15. Micromechanical component for a micromechanical system, in particular a watch movement, wherein said component is coated with electrically conductive nanocrystalline diamond, said diamond coating surface being further doped with an element or material rendering the surface hydrophobic said element or material being selected from the list including fluorine, wax, oils and wherein the diamond coating is H-terminated or F-terminated and wherein said diamond layer is formed of diamond grains having a size less than 30 nanometers and preferably less than 10 nanometers and most preferably less than 8 nanometers.

## Patentansprüche

1. Verfahren zum Beschichten mikromechanischer Komponenten eines mikromechanischen Systems, insbesondere eines Uhrwerks, umfassend:
- Bereitstellen einer zu beschichteten Substratkomponente und
- Versehen dieser Komponente mit einer Diamantbeschichtung; wobei
- die Leitfähigkeit der Diamantbeschichtung erhöht wird, um das Anziehen von Partikeln (Schmutz/Staub) durch die beschichtete Komponente bei Verwenden derselben im mikromechanischen System zu verringern, und wobei die Diamantbeschichtungsoberfläche ferner dotiert ist mit einem Element oder einem Material, das die Oberfläche hydrophob macht, wobei das Element oder das Material aus der Liste ausgewählt ist, die Fluor, Wachs und Öle enthält, und die Diamantbeschichtung derart abgeschieden wird, dass sie H-terminiert oder F-terminiert ist, und
- die Diamantschicht aus Diamantkörnern gebildet ist, die eine Größe von weniger als 30 Nanometern, bevorzugt weniger als 10 Nanometern und besonders bevorzugt weniger als 8 Nanometern besitzen.

2. Verfahren zum Beschichten mikromechanischer Komponenten eines mikromechanischen Systems nach Anspruch 1, wobei
- die Diamantbeschichtung durch CVD ausgeführt wird und
- während der CVD-Ablagerung die elektronische Leitfähigkeit der Beschichtung durch Dotierung der Diamantschicht erhöht wird.

3. Verfahren zum Beschichten mikromechanischer Komponenten eines mikromechanischen Systems nach Anspruch 2, wobei die Dotierung durch Hinzufügen eines Dotierungsstoffes in gasförmiger Form, flüssiger Form, fester Form und/oder Dampfform während des Abscheidungsvorgangs erreicht wird.

4. Verfahren zum Beschichten mikromechanischer Komponenten eines mikromechanischen Systems nach Anspruch 3, wobei der Dotierungsstoff ein Material oder eine Kombination der Materialien ist, ausgewählt aus der Gruppe, die aus Bor, Phosphor, Stickstoff, Schwefel, Arsen und Aluminium besteht.

5. Verfahren zum Beschichten mikromechanischer Komponenten eines mikromechanischen Systems nach Anspruch 1, wobei die elektronische Leitfähigkeit der Beschichtung durch Dotierung der Diamantschicht erhöht wird, wobei die Dotierung mittels Ionenimplantation, lonenbeschuss oder einer SputterTechnik erreicht wird.

6. Verfahren zum Beschichten mikromechanischer Komponenten eines mikromechanischen Systems nach Anspruch 1, wobei die elektronische Leitfähigkeit der Beschichtung durch Dotierung der Diamantschicht erhöht wird, wobei die Dotierung durch Abscheiden von Adsorbaten erreicht wird.

7. Verfahren zum Beschichten mikromechanischer Komponenten eines mikromechanischen Systems nach Anspruch 1, wobei die elektronische Leitfähigkeit der Beschichtung durch Dotierung der Diamantschicht erhöht wird, wobei die Dotierung durch Deuterierung und Nachhydrierung erreicht wird.

8. Verfahren zum Beschichten mikromechanischer Komponenten eines mikromechanischen Systems nach Anspruch 1, wobei die elektronische Leitfähigkeit der Beschichtung durch Dotierung der Diamantschicht erhöht wird, wobei die Dotierung durch Gitterstörungen erreicht wird.

9. Verfahren zum Beschichten mikromechanischer Komponenten eines mikromechanischen Systems nach Anspruch 1, wobei die elektronische Leitfähigkeit der Beschichtung durch Dotierung der Diamantschicht erhöht wird, wobei die Dotierung durch Terminieren der nanokristallinen Diamantoberfläche mit einem Element oder einem Material, das die Oberfläche hydrophob macht, erreicht wird.

10. Verfahren zum Beschichten mikromechanischer Komponenten eines mikromechanischen Systems nach Anspruch 9, wobei die Terminierung unter Verwendung eines Elements vorgesehen ist, ausgewählt aus der Liste, die aus Wasserstoff, Halogenen, Metallen, elektrisch leitfähigen Mineralen/organischen Molekülen oder Proteinen besteht.

11. Mikromechanische Komponente für ein mikromechanisches System, insbesondere ein Uhrwerk, wobei die Komponente mit einem Verfahren nach einem der Ansprüche 1 bis 10 erhalten wird.

12. Mikromechanische Komponente, umfassend ein Lager nach Anspruch 11, wobei das Lager mit elektrisch leitfähigem nanokristallinem Diamant nach einem der Ansprüche 1 bis 10 beschichtet ist.

13. Mikromechanische Komponente, umfassend ein Lager nach Anspruch 11 oder 12, wobei das Lager des mikromechanischen Systems und die verwendeten Klebstoffe elektrisch leitend sind, um zu ermöglichen, dass elektrische Ladungen abgeführt werden können.

14. Mikromechanisches System, insbesondere ein Uhrwerk, umfassend eine Komponente, die mit einem Verfahren nach einem der Ansprüche 1 bis 10 erhalten wird, und ferner umfassend mindestens eine Silizium-Ausgangskomponente, wobei das Silizium-Ausgangsmaterial elektrisch leitfähig ist.

15. Mikromechanische Komponente für ein mikromechanisches System, insbesondere ein Uhrwerk, wobei die Komponente mit elektrisch leitfähigem nanokristallinem Diamant beschichtet ist und die Diamantbeschichtungsoberfläche ferner mit einem Element oder einem Material dotiert ist, das die Oberfläche hydrophob macht, wobei das Element oder Material ausgewählt ist aus der Liste, die Fluor, Wachs und Öle enthält, und wobei die Diamantbeschichtung H-terminiert oder F-terminiert ist, und wobei die Diamantschicht aus Diamantkörnern gebildet ist, die eine Größe von weniger als 30 Nanometern, bevorzugt weniger als 10 Nanometern und besonders bevorzugt weniger als 8 Nanometern besitzen.

## Revendications

1. Procédé de revêtement de composants micromécaniques d'un système micromécanique, en particulier un mouvement de montre, comprenant :
- la fourniture d'un composant de substrat à revêtir ;
- la fourniture dudit composant avec un revêtement en diamant ;
- dans lequel la conductivité dudit revêtement en diamant est accrue pour réduire une attraction de particules (débris/poussières) par le composant revêtu lorsqu'il est utilisé dans ledit système micromécanique, et dans lequel la surface de revêtement en diamant est en outre dopée avec un élément ou un matériau rendant la surface hydrophobe, ledit élément ou matériau étant sélectionné dans la liste comprenant du fluor, une cire, des huiles, et dans lequel le revêtement en diamant est déposé de manière à être terminé en H ou à être terminé en F, et
- dans lequel ladite couche de diamant est constituée de grains de diamant présentant une taille inférieure à 30 nanomètres, de préférence inférieure à 10 nanomètres et avec le plus de préférence inférieure à 8 nanomètres.

2. Procédé de revêtement de composants micromécaniques d'un système micromécanique selon la revendication 1, dans lequel :
- le revêtement en diamant est fourni par dépôt en phase vapeur, CVD;
- au cours du dépôt CVD, une conductivité électronique dudit revêtement est accrue par le dopage du film en diamant.

3. Procédé de revêtement de composants micromécaniques d'un système micromécanique selon la revendication 2, dans lequel ledit dopage est réalisé en ajoutant un dopant sous forme gazeuse, liquide, solide et/ou vapeur au cours du processus de dépôt.

4. Procédé de revêtement de composants micromécaniques d'un système micromécanique selon la revendication 3, dans lequel le dopant est un matériau ou une combinaison de matériaux sélectionnés dans le groupe se composant de bore, phosphore, azote, souffre, arsenic et aluminium.

5. Procédé de revêtement de composants micromécaniques d'un système micromécanique selon la revendication 1, dans lequel une conductivité électronique dudit revêtement est accrue par le dopage du film en diamant, ledit dopage étant réalisé au moyen d'une implantation d'ions, d'un bombardement d'ions ou d'une technique de pulvérisation.

6. Procédé de revêtement de composants micromécaniques d'un système micromécanique selon la revendication 1, dans lequel une conductivité électronique dudit revêtement est accrue par le dopage du film en diamant, ledit dopage étant réalisé par le dépôt d'adsorbats.

7. Procédé de revêtement de composants micromécaniques d'un système micromécanique selon la revendication 1, dans lequel une conductivité électronique dudit revêtement est accrue par le dopage du film en diamant, ledit dopage étant réalisé par déutération et post-hydrogénation.

8. Procédé de revêtement de composants micromécaniques d'un système micromécanique selon la revendication 1, dans lequel une conductivité électronique dudit revêtement est accrue par le dopage du film en diamant, ledit dopage étant réalisé par distorsion de réseau.

9. Procédé de revêtement de composants micromécaniques d'un système micromécanique selon la revendication 1, dans lequel une conductivité électronique dudit revêtement est accrue par le dopage du film en diamant, ledit dopage étant réalisé par la terminaison de la surface en diamant nanocristallin avec un élément ou un matériau rendant la surface hydrophobe.

10. Procédé de revêtement de composants micromécaniques d'un système micromécanique selon la revendication 9, dans lequel ladite terminaison est fournie en utilisant un élément sélectionné dans la liste se composant d'hydrogène, halogènes, métaux, molécules minérales/organiques électriquement conductrices ou protéines.

11. Composant micromécanique pour un système micromécanique, en particulier un mouvement de montre, dans lequel ledit composant est obtenu avec un procédé selon l'une quelconque des revendications 1 à 10.

12. Composant micromécanique selon la revendication 11, comprenant des paliers, dans lequel les paliers sont revêtus de diamant nanocristallin électriquement conducteur selon l'une quelconque des revendications 1 à 10.

13. Composant micromécanique selon la revendication 11 ou 12, dans lequel les paliers du système micromécanique et les colles utilisées sont électriquement conducteurs pour permettre l'évacuation de charges électriques.

14. Système micromécanique, en particulier un mouvement de montre, comprenant un composant obtenu avec un procédé selon l'une quelconque des revendications 1 à 10, et comprenant en outre au moins un composant à base de silicium, dans lequel le composant à basse de silicium est électriquement conducteur.

15. Composant micromécanique pour un système micromécanique, en particulier un mouvement de montre, dans lequel ledit composant est revêtu d'un diamant nanocristallin électriquement conducteur, ladite surface de revêtement en diamant étant en outre dopée avec un élément ou un matériau rendant la surface hydrophobe, ledit élément ou matériau étant sélectionné dans la liste se composant de fluor, de cire, et d'huiles, dans lequel le revêtement en diamant est terminé en H ou terminé en F, et dans lequel ladite couche de diamant est constituée de grains de diamant présentant une taille inférieure à 30 nanomètres, de préférence inférieure à 10 nanomètres et avec le plus de préférence inférieure à 8 nanomètres.
